# EUROPÄISCHE PATENTSCHRIFT

(11) **EP 3 230 795 B1**
(45) Veröffentlichungstag und Bekanntmachung des Hinweises auf die Patenterteilung: **05.06.2019**
(21) Anmeldenummer: 15817053.0
(22) Anmeldetag: 09.12.2015
(51) Int. Cl.: G03F 7/00, G03F 7/027, G03F 7/028, G03F 7/004, G03F 7/029, G03F 7/031, G03F 7/075

(54) **PRÄGELACK SOWIE VERFAHREN ZUM PRÄGEN**
EMBOSSING LACQUER AND METHOD FOR EMBOSSING
VERNIS D'EMBOSSAGE ET PROCÉDÉ D'EMBOSSAGE

(30) Priorität: 10.12.2014 AT 8872014
(43) Veröffentlichungstag der Anmeldung: 18.10.2017
(73) Patentinhaber: Joanneum Research Forschungsgesellschaft mbH, 8010 Graz (AT)
(72) Erfinder: NEES, Dieter, 8160 Thannhausen (AT); AUNER, Christoph, 8020 Graz (AT); STADLOBER, Barbara, 8044 Graz (AT); RUTTLOFF, Stephan, 8160 Weiz (AT); BELEGRATIS, Maria, 8212 Pischelsdorf (AT)
(74) Vertreter: Strehl Schübel-Hopf & Partner
(86) Internationale Anmeldenummer: PCT/AT2015/000156
(87) Internationale Veröffentlichungsnummer: WO 2016/090394

(56) Entgegenhaltungen:
- EP-A1- 2 286 980
- GB-A- 2 003 494
- GB-A- 2 089 581
- US-A1- 2008 176 049
- US-A1- 2010 109 317

## Beschreibung

Die vorliegende Erfindung bezieht sich auf einen Prägelack basierend auf einer UV-polymerisierbaren Präpolymerzusammensetzung enthaltend wenigstens ein Acrylatmonomer, sowie ein Verfahren zum Prägen von mit einem Prägelack, basierend auf einer UV-polymerisierbaren Propolymerzusammensetzung enthaltend wenigstens ein Acrylatmonomer, beschichteten Substratoberflächen.

Durch den rasanten Aufschwung der Nanotechnologie in den letzten Jahren gewinnt die Herstellung von nanostrukturierten Komponenten in der industriellen Fertigung zusehends an Bedeutung, wobei derartige nanostrukturierte Komponenten üblicherweise aus fotopolymerisierbaren Präpolymerzusammensetzungen hergestellt werden. Insbesondere in dem Dekorbereich, dem Produktmarketing und der Oberflächenveredelung verschiedenster Werkstoffe, wie z. B. Folien werden zunehmend feinste Strukturen eingesetzt, um bestimmte zusätzliche Funktionen zu erzielen, wie z.B. dekorative optische Effekte hervorzurufen. Hierfür werden nanotechnologisch aufbereitete Strukturen, welche aus speziellen Präpolymerzusammensetzungen gefertigt sind, eingesetzt.

Ein noch bedeutender Einsatzzweck von derartigen mikro- und nanostrukturierten Folien ist bei elektronischen, optischen, sensorischen und magnetischen Bauelementen, wie integrierten Schaltkreisen, Displays, Mikrooptiken und dgl., da kleine Strukturgrößen für die Funktionalität dieser Elemente der entscheidende Faktor sind, und es existieren daher intensive Bemühungen auf dem Gebiet der großflächig gedruckten Elektronik, Bauelemente auf Foliensubstraten zu fertigen. Für die industrielle Folienfertigung spielen daher Mikro- und Nanostrukturierungstechniken, wie Imprinttechnologien eine wichtige Rolle und erfordern immer neue und verbesserte abformbare Folien oder Zusammensetzungen, aus welchen derart strukturierte Folien herstellbar sind.

Die industrielle Folienveredelung umfasst einen sehr großen Bereich, der von der Verbesserung der mechanischen oder dekorativen Oberflächeneigenschaften bis zur Integration von optischen, sensorischen und elektronischen Funktionalitäten in der Werkstofffolie reicht. Ein entscheidendes Kriterium und gleichzeitig eine limitierende Komponente für den Einsatz derartiger Produktionstechniken ist allerdings das Faktum, dass Produkte häufig Strukturen mit Dimensionen im unteren Mikrometer- oder Nanometerbereich aufweisen, einerseits wegen der hohen Integrationsdichte ihrer Einzelkomponenten, aber auch, um die Funktionalität der Strukturen in der Größenordnung der verwendeten Wellenlänge zu gewährleisten und die Oberflächen insgesamt zu vergrößern. Herkömmliche Massendruckverfahren, wie Tiefdruck, Flexodruck, Siebdruck, Offsetdruck und dgl. erlauben zwar einen extrem hohen Durchsatz von mehreren 100 m pro Minute, schaffen es jedoch üblicherweise nicht, den notwendigen strukturellen Auflösungsbereich zur Verfügung zu stellen. Die einzige derzeit bekannte Technik, die es ermöglicht, Strukturen mit minimalen Dimensionen im Nanometerbereich in einem parallelen Verfahren herzustellen, ist die sogenannte Nanoimprintlithographie (NIL), welche ein hoch präzises Prägeverfahren darstellt und mit welchem es möglich ist, auch kleinste Strukturen auf dem entsprechenden Substrat auszuformen.

Aus der EP 2 286 980 A1 ist bereits eine Form bestehend aus einem geformten Harz ebenso wie ein Verfahren zur Herstellung desselben bekannt geworden, mit welchem robuste und gleichzeitig feine Strukturen auf einer Oberfläche ausgebildet werden können. Eine für die Ausbildung der Form einsetzbare photohärtbare Harzzusammensetzung enthält einen Polymerisationsindikator ebenso wie ein entsprechendes photopolymerisierbares Monomer.

Nanoimprintlithographieverfahren werden industriell bis dato vor allem zur Erzeugung von Prägehologrammen eingesetzt. Hierfür werden in dem Nanoimprintlithographieverfahren ähnliche Prozesse verwendet, wobei die geprägten Strukturen ein Oberflächenrelief darstellen, das als Beugungsgitter wirkt. Entscheidend bei derartigen Verfahren ist, dass ein Anhaften des Lacks am Prägewerkzeug vermieden wird, um nachfolgend eine defektfreie Entformung des geprägten Gegenstands erzielen zu können.

Für ein Nanoimprintverfahren werden gegenwärtig zwei verschiedene Arten von Prägewerkzeugen verwendet. Gegenwärtig werden als derartige Prägewerkzeuge aus Silizium, Quarz oder Nickel eingesetzt, wobei die Fertigung von derartigen harten Prägewerkzeugen relativ kompliziert ist. Es gibt daher Bestrebungen, die harten Prägestempel durch Prägestempel aus Polymermaterialien zu ersetzen, wobei Polymermaterialien potentiell niedrigere Oberflächenenergien als Silizium, Quarz oder Nickel aufweisen, was die Lackanhaftung des Prägelacks beim Prägeprozess verringert. Allerdings haben sie oft den Nachteil, dass sie als Prägestempel im Submikrometerbereich nur sehr begrenzt eingesetzt werden können und dass vernetzte Polymermaterialien im Prägeverfahren nicht schnell genug ausreichend aushärten und somit ihre Prägetreue relativ gering ist, so dass eine defektfreie Selbstreplikation des Stempels in einem Prägeverfahren mit derzeit verfügbaren Prägelacken nicht möglich erscheint. Für eine Prägung ist nicht nur die vollständige Umsetzung der reaktiven C-C-Doppelbindungen im Polymer-Stempelmaterial vor der Prägung notwendig, weil diese sonst mit den C-C-Doppelbindungen im eingesetzten Prägelack reagieren, was zwangsläufig zum Verkleben von Stempel und Lack führt. Insbesondere bei kleinen Strukturen, wie im Nanometerbereich ist jedoch jegliches Verkleben von Stempel und Lack bzw. jegliches nicht vollständiges Ablösen der geprägten Struktur von dem Werkzeug unbedingt zu vermeiden, da ansonsten ein Abformen mit einer erforderlichen Strukturtreue nicht möglich ist und gewünschte Strukturen nicht mit einer derartigen Formtreue hergestellt werden können, um sie industriell einsetzen zu können. Hierfür sind die Oberflächeneigenschaften bzw. Grenzflächenenergien zwischen einem Substrat, dem Stempel und dem Prägelack entscheidend. Ein rückstandsfreies Entformen erscheint nur dann möglich, wenn der Prägelack eine stark ausgeprägte Tendenz zeigt, sich von der Stempeloberfläche während des Nanoimprintverfahrens zurückzuziehen.

Die vorliegende Erfindung zielt nun darauf ab, einen löslichen Prägelack basierend auf einer UV-polymerisierbaren Präpolymerzusammensetzung zur Verfügung zu stellen, mit welchem es gelingt, Strukturen im Nanometerbereich herzustellen und welche frei von Unregelmäßigkeiten sind. Die Erfindung zielt weiterhin auf die Bereitstellung eines Verfahrens zum Prägen von mit einem derartigen Prägelack beschichteten Substratoberflächen ab, mit welchem Verfahren es gelingt, selbstabformbare Strukturen im Nanometerbereich des Prägelacks herzustellen, welche eine hohe Abformtreue aufweisen und es ermöglichen, defektfreie Nanostrukturen in einem kontinuierlichen Nanoimprintlithographieverfahren herzustellen.

Zur Lösung dieser Aufgabe ist ein erfindungsgemäßer Prägelack im Wesentlichen dadurch gekennzeichnet, dass die Präpolymerzusammensetzung neben den Acrylatmonomeren wenigstens ein Thiol, gewählt aus der Gruppe: 3-Mercaptopropionate, Mercaptoacetate, Thioglycolate und Alkylthiole sowie gegebenenfalls ein oberflächenaktives Antihaftadditiv gewählt aus der Gruppe nicht-ionischen Tenside, wie Polyether-Siloxane, Fettalkoholethoxylate, wie Polyoxyethylen-(9)-laurylether, monofunktionelle Alkyl-(Meth-)Acrylate, Poly-Siloxan-(Meth-)Acrylate, Perfluoralkyl-(Meth-)Acrylate und Perfluorpolyether-(Meth-)Acrylate, sowie ein Photoinitiator enthält. Indem gemäß der Erfindung die Präpolymerzusammensetzung neben den Acrylatmonomeren wenigstens ein Thiol gewählt aus der Gruppe 3-Mercaptopropionate, Mercaptoacetate, Thioglycolate und Alkylthiole enthält, werden bei fehlendem O₂-Ausschluss während der Polymerisation entstehende Peroxyradikale Wasserstoffatome von den Thiolgruppen unter Bildung von Thionylradikalen abstrahieren, welche Thionylradikale sich wiederum an die Kohlenstoff-Kohlenstoff-Doppelbindungen addieren und eine Polyadditionsreaktion starten, wodurch der Kettenabbruch verhindert und die Reaktionsgeschwindigkeit deutlich erhöht wird und insbesondere die UV-Polymerisation rasch weitergeführt, was insgesamt zu einer Erhöhung der Polymerisationsgeschwindigkeit führt. Die Thiol-Zugabe bewirkt einen verstärkten Kettenübertrag bei der radikalischen Polymerisation bzw. ermöglicht eine parallele Polyadditionsreaktion, wodurch es gelingt, das gleichzeitige Wachstum vieler Reaktionszentren anzuregen, was wiederum zu geringeren Molekulargewichten bzw. Polymerkettenlängen und damit verbesserter Löslichkeit der daraus gebildeten Polymere führt.

Durch den Einsatz des Thiols erfolgt insbesondere die während der Polymerisation zwangsläufig auftretende Schrumpfung bereits im flüssigen Zustand der UV-polymerisierbaren Präpolymerzusammensetzung, wodurch in einem Prägeprozess, insbesondere UV-Prägeprozess, die Abformtreue gegenüber herkömmlichen Materialen deutlich verbessert und insbesondere die die Prägetreue beeinträchtigende Schrumpfung gegenüber herkömmlichen UV-Präge-Polymeren deutlich verringert ist. Bei diesem Einsatz eines oberflächenaktiven Antihaftadditives wird die Adhäsionsenergie, d.h. die Haftung zwischen dem Prägelack und einem Shim oder Stempel während eines nachfolgenden Einsatzes deutlich verringert, was eine rückstandsfreie Trennung bzw. ein rückstandfreies voneinander Lösen der zwei Materialien ermöglicht.

Der erfindungsgemäße Prägelack besitzt eine besonders niedrige Viskosität, welche das rasche Auffüllen von Kavitäten im Prägewerkzeug erlaubt und die Abformung von Nanostrukturen ermöglicht. Die Oberflächenenergie und/oder die Grenzflächenenergien des Prägelacks ist durch Zusatz von grenzflächenaktiven Additiven steuerbar und damit auch das Benetzungsverhalten des Prägelacks.

Der erfindungsgemäße Prägelack ermöglicht hierbei eine direkte Lift-Off-Strukturierung von in einem zweiten Schritt aufgedampften Schichten, da der Prägelack derart vollständig entfernt werden kann, dass keine Rest-Lackschicht zwischen den Opferlackstrukturen auf der Substratfolie verbleibt. Es erübrigt sich daher bei Einsatz des Prägelacks eine Restlackentfernung beispielsweise durch ein zeitaufwändiges O₂-Plasmaätzen.

Indem, wie dies einer Weiterbildung der Erfindung entspricht, der Prägelack so ausgebildet ist, dass Acrylatmonomer aus der Gruppe Acryloylmorpholin (ACMO) oder Isobornylacrylat (IBOA) gewählt ist, wird als Acrylatmonomer ein extrem kleines, bewegliches, reaktives Monomer eingesetzt, wodurch die Polymerisationsgeschwindigkeit insgesamt stark erhöht werden kann und ein besonders rasches Aushärten und somit eine hohe Abformtreue des Prägelacks sichergestellt werden kann.

Um den Polymerisationsgrad der den Prägelack ausbildenden Zusammensetzung während der UV-Prägung/Verfestigung möglichst gering zu halten und damit die Löslichkeit bzw. Lösegeschwindigkeit zu maximieren, ist der erfindungsgemäße Prägelack dahingehend weitergebildet, dass das Thiol in einer Menge zwischen 0,5 und 20 Gew.-% der Präpolymerzusammensetzung enthalten ist. Mit einer derartigen Weiterbildung gelingt es die bei der Polymerisation auftretende, die Prägetreue beeinträchtigende Schrumpfung möglichst gering zu halten.

Um insbesondere ein Anhaften des Prägelacks während bzw. nach der UV-Polymerisation der diesen ausbildenden Präpolymerzusammensetzung an Oberflächen, wie beispielsweise einer Nickelshim-Oberfläche so gering wie möglich zu halten oder ganz hintanzuhalten, ist die Erfindung dahingehend weitergebildet, dass das oberflächenaktive Antihaftadditiv ein silikonhaltiges oder fluorhaltiges Additiv, gewählt aus der Gruppe der nicht-ionischen Tenside wie Polyether-Siloxane, Fettalkoholethoxylate wie Polyoxyethylen-(9)-laurylether, monofunktionellen Polydimethylsiloxian-(meth-)acrylate, Perfluor-n-alkyl-(meth-)-acrylate oder Perfluorpolyether(meth-)-acrylate ist, welches insbesondere in einer Menge von 0,1 bis 3 Gew.-% enthalten ist. Silikonhaltige oder fluorhaltige Additive tragen zur Verringerung der Adhäsion und zur Erleichterung der Ablösung der aus der Präpolymerzusammensetzung gebildeten Prägelacke von dem Prägewerkzeug bei, wobei sich insbesondere die perfluorierten Additive als besonders günstig erwiesen haben und eine Mehrzahl von Abformungen eines Musters zuverlässig ermöglichen.

Indem, wie dies einer Weiterbildung der Erfindung entspricht, der in der den Prägelack ausbildenden Präpolymerzusammensetzung enthaltene Photoinitiator aus der Gruppe der Thioxanthone, Ketosulphone, (Alkyl-)Benzoyl-Phenyl-Phosphinoxide, 1-Hydroxyalkylphenylketone oder 2,2-Dimethoxy-1,2-diphenylethan-1-on gewählt ist, gelingt es, die Polymerisation effektiv zu initiieren.

Indem, wie dies einer Weiterbildung der Erfindung entspricht, der Photoinitiator in einer Menge von 0,1 bis 10 Gew.-%, insbesondere 0,5 bis 5 Gew.-% enthalten ist, kann die Polymerisationsgeschwindigkeit der den Prägelack ausbildenden Zusammensetzung gezielt gesteuert werden. Allgemein ist festzuhalten, dass, je höher die Konzentration des Photoinitiators ist, desto größer ist die Polymerisationsgeschwindigkeit in den verwendeten dünnen Schichten, so dass sich insbesondere eine Menge von 0,5 bis 5 Gew.-% des Photoinitiators für eine Polymerisation entsprechend dem erfindungsgemäßen Einsatz als vorteilhaft erwiesen hat.

Um einen insbesondere eine hohe Polymerisationsgeschwindigkeit aufweisenden sowie einen niedrigen Polymerisationsgrad aufweisenden Prägelack auszubilden, ist die Erfindung so weitergebildet, dass das Thiol aus einem Mono- oder Dithiol der Gruppe: Octanthiol, 1,8-Octandithiol, Decanthiol, 1,10-Decandithiol, Dodecanthiol, 1,12-Dodecandithiol, 2-Ethylhexylmercaptoacetat, 2-Ethylhexyl-3-mercaptopropionat, 2-Ethylhexylthioglycolat, Glycoldi-(3-mercaptoproprionat), Gykoldi(mercaptoacetat), Glyceryldimercaptoacetat oder Glyceryldi-(3-mercaptopropionat) gewählt ist.

Um ein Residuum-freies Prägen des Prägelacks zu gewährleisten ist die Erfindung dahingehend weitergebildet, dass die Präpolymerzusammensetzung eine Viskosität zwischen 10 und 100 mPas aufweist.

Die Erfindung bezieht sich weiterhin auf ein Verfahren zum Prägen von mit einem Prägelack gemäß der Erfindung beschichteten Substratoberfläche, wobei es im vorliegenden Fall offensichtlich ist, dass das erfindungsgemäße Verfahren auf die unterschiedlichsten Weisen geführt werden kann, ohne dass das Ergebnis gemäß der Erfindung verändert wird. Aufgabe eines derartigen Verfahrens ist es, nanostrukturierte Flächen bzw. Strukturen auszubilden bzw. herzustellen und diese Strukturen eine Mehrzahl von Malen mit einem gängigen Abformverfahren bzw. Imprintverfahren abzuformen.

Zur Lösung dieser Aufgabe ist das erfindungsgemäße Verfahren im Wesentlichen gekennzeichnet durch die Schritte:
a) Aufbringen einer Schicht des Prägelacks auf einen Träger,
b) UV-Strukturieren des Prägelacks,
c) gegebenenfalls Aufbringen wenigstens einer weiteren zu strukturierenden Schicht gewählt aus einer Metall-, Halbleiter- und/oder Dielektrikumschicht,
d) Ablösen des nach dem Strukturieren in Schritt b) verbleibenden Prägelacks mit gegebenenfalls Zusätzen gewählt aus verdünnten Säuren mit pH-Werten im Bereich von 1 bis 6, verdünnten Laugen mit pH-Werten im Bereich von 8 bis 13 oder Tenside enthaltendem Wasser oder Propylenglycolmonomethyletheracetat (PGMEA), N-Methyl-2-pyrrolidon (NMP), Methylethylketon (MEK) oder Aceton.

Indem von dem erfindungsgemäßen Verfahren die ersten zwei Schritte durchgeführt werden, gelingt es, eine nanostrukturierte Lackschicht als Opferschicht herzustellen, welche entweder metallisiert oder mit einer anderen Schicht belegt werden kann und in der Folge die verbliebenen Strukturen des Prägelacks mittels Wasser oder organischen Lösungsmitteln, wie PGMEA abgelöst werden können. Bevorzugt ist an einem derartigen Verfahren, dass der auf ACMO basierende Prägelack in Wasser, verdünnten Säuren oder Laugen bzw. spezifischen Lösungsmitteln löslich ist, so dass die Anwendung von giftigen bzw. stark ätzenden Chemikalien jedenfalls vermieden werden kann und weiterhin mit einem derartigen Verfahren eine Nanostruktur großflächig ausgebildet werden kann.

Um eine exakt reproduzierbare Strukturierung der Oberfläche des Prägelacks zu erreichen oder auch eine exakte Strukturierung der metallisierten Oberflächen desselben zu erreichen, wird das erfindungsgemäße Verfahren im Wesentlichen so geführt, dass die UV-Strukturierung des Prägelacks mit einem UV-Nanoimprintlithographieverfahren durchgeführt wird.

Indem, wie dies einer Weiterbildung der Erfindung entspricht, die weitere zu strukturierende Schicht aus Metallen wie Nickel, Aluminium, Chrom oder Titan, konjugierten organischen Halbleitern wie Pentazen, C60, Thiophenen, DNTT; P3HT, Phthalocyaninen, H-brückengebundenen organischen Halbleitern, wie Indigo und Indigo-derivaten sowie Quinacridon und Anthraquinon, anorganischen Halbleitern wie ZnO, SnO, InGaZnO oder Dielektrika, gewählt aus Polynorbornen, Ormocere, Cellulose, PVCi, BCB, PMMA, Schellack, Polyimid, Cytop, PVDF, PVDF-TrFE, Polystyrole, Al₂O₃, ZrO₂, SiO₂, SiON. Si₃N₄ sowie Kombinationen daraus aufzubringen, mit welchen Schichten eine defektfreie Ablösung erzielt werden können.

Besonders gute Ergebnisse können dadurch erreicht werden, dass das Verfahren so geführt wird, dass die weitere zu strukturierende Metall-, Halbleiter- und/oder Dielektrikumschicht mit einer Schichtdicke zwischen 5 nm und 500 nm aufgebracht wird wobei die Stärke der zu strukturierenden Schicht kleiner 1/3 der strukturierten sein sollte.

Die nach NIL-Prägeprozessen normalerweise notwendige Entfernung der verbleibenden Rest-Lackschicht durch einen Ätzschritt ist wegen der Residuum-Freiheit des beschriebenen UV-Prägeprozesses obsolet.

Indem, wie dies einer Weiterbildung der Erfindung entspricht, das Ablösen des nach dem Strukturieren verbliebenen Prägelacks, durch Tauchen in ein Lösungsmittelbad oder durch Sprühen, gegebenenfalls mit zusätzlichen mechanischen Hilfsmitteln, wie Bürsten oder Ultraschall, durchgeführt wird, gelingt es, ein einfach durchzuführendes, umweltfreundliches Verfahren zur Verfügung zu stellen, mit welchem jegliche Reste des Prägelacks rückstandsfrei entfernt werden können. Mit einer derartigen Verfahrensführung und unter Einsatz des oben genannten Prägelacks gelingt es, jegliches Sauerstoff-Plasma-Ätzen (RIE-Verfahren) zu vermeiden.

Die Erfindung wird nachfolgend anhand von in der Zeichnung dargestellten Beispielen sowie Ausführungsbeispielen näher erläutert. In diesen zeigen:
Fig. 1 eine schematische Darstellung eines Residuum-freien Prägens durch Entnetzung des UV-Prägelacks,
Fig. 2 eine Rasterelektronendarstellung einer Residuum-freien UV-NIL-Prägung einer PET-Folie, und
Fig. 3 eine schematische Darstellung des Lift-Off-Prinzips auf Basis eines Lift-Off-fähigen Prägelacks gemäß der Erfindung als Opferschicht, und
Fig. 4 vier Rasterelektronenmikroskopaufnahmen von Linien- bzw. Gitterstrukturen, welche mit einem Prägelack gemäß der vorliegenden Erfindung hergestellt wurden.

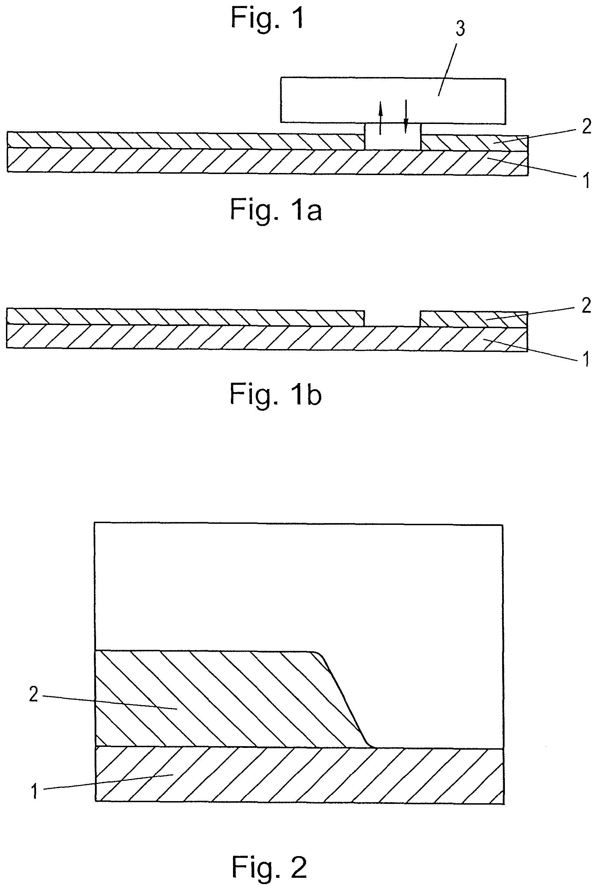

In Fig. 1 ist gezeigt, dass ein Substrat 1 mit einem auf Acrylat basierenden UV-Resist 2, welcher auch oberflächenaktive Substanzen enthält, beschichtet wird. Bei Annäherung eines Prägestempels 3 wird aufgrund der Benetzungseigenschaften des Resists 2 der Spaltungskoeffizient, d.h. die Grenzflächenenergie zwischen Substrat 1 und Stempel 3 minus der Grenzflächenenergie zwischen Substrat 1 und Resist 2 und zwischen Resist 2 und Stempel 3 negativ, wodurch der Resist 2 sich zwischen Stempeloberfläche und Substrat 1 zurückzieht, wie dies in Fig. 1b dargestellt ist, welche den ausgehärteten UV-Prägelack nach Entfernen des Prägestempels 3 zeigt, welcher Prägelack 2 eine dem Stempel 3 entsprechende Lücke 4 aufweist.

Durch ein derartiges Residuum-freies UV-NIL-Prägen erübrigt sich der bei dem Nanoimprintlithographieverfahren generell notwendige Sauerstoff-Plasma-Ätzschritt (RIE) zur Entfernung von allfälligen Restlackschichten auf dem Substrat 1, wie dies in Fig. 2 dargestellt ist. Fig. 2 zeigt deutlich, dass auf der Substratfolie 1, welche mit Prägelack 2 beschichtet ist, kein Rückstand des Prägelacks 2 vorhanden ist, wo der Prägestempel 3 zur Entnetzung des UV-Resists auf dem Substrat geführt hat.

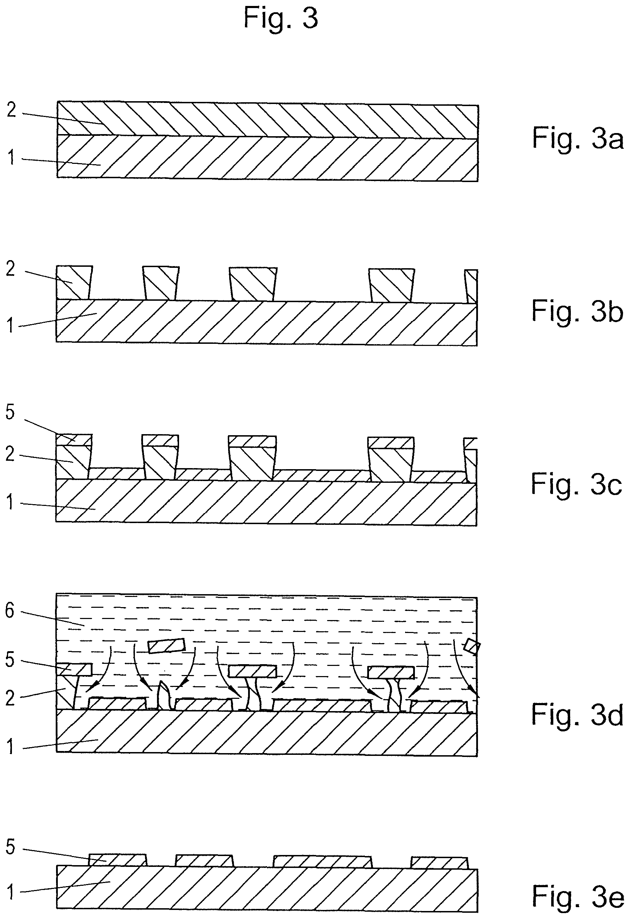

In Fig. 3 ist schematisch die Abfolge von Verfahrensschritten eines Lift-Off-Prozesses dargestellt.

In Fig. 3a wird auf ein Substrat 1 eine Opferschicht, z.B. ein Photolack 2 aufgebracht. In Fig. 3b ist ersichtlich, dass die Opferschicht 2 strukturiert wurde und zwar im vorliegenden Fall mit einem negativen Seitenwandwinkel.

In Fig. 3c ist die gesamte Oberfläche von sowohl dem freigelegten Substrat 1 als auch der verbliebenden Opferschicht 2 mit einem Zielmaterial, beispielsweise Aluminium 5 abgedeckt.

In Fig. 3d ist schematisch das Auflösen der Opferschicht bzw. des Resists 2 in einem nasschemischen Verfahren, im vorliegenden Fall in Wasser, dargestellt. Die Opferschicht 2 löst sich in Wasser 6 auf und sämtliche Bereiche des Substrats 1, auf welchen eine Opferschicht 2 in den vorhergehenden Schritten verblieben ist, werden von der Opferschicht 2 freigelegt und gemeinsam mit der Opferschicht 2 wird das sich über der Opferschicht 2 befindliche Zielmaterial 5 abgelöst bzw. entfernt, so dass Substrat 1 mit dem abgeschiedenen Zielmaterial 5 zurückbleibt. Nach einem Trocknen des Substrats 1 ist das strukturierte Zielmaterial 5 auf dem Substrat 1 für die Weiterverwendung bereit, wie dies in Fig. 3e dargestellt ist.

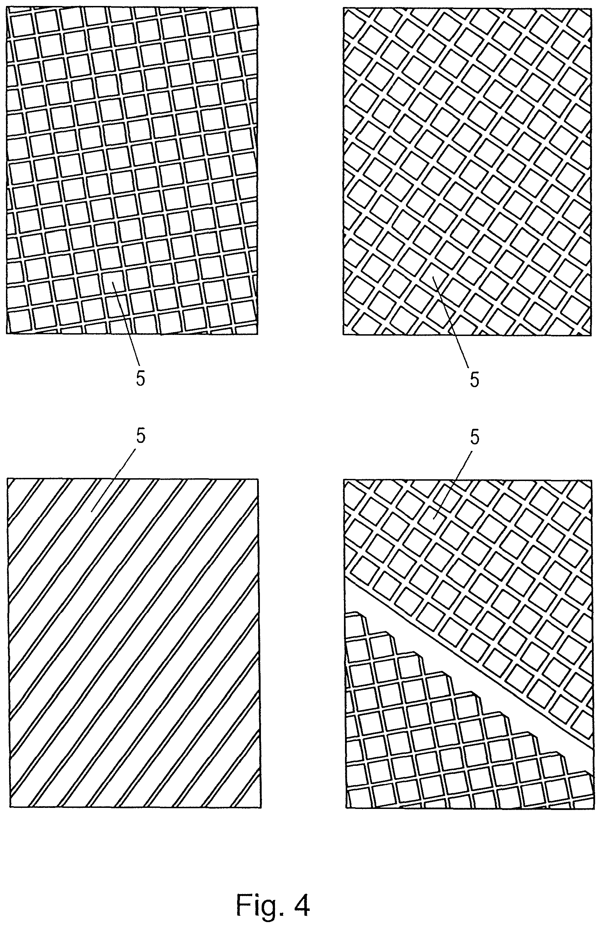

In Fig. 4 sind Bilder von strukturierten Zielmaterialien 5 dargestellt, wobei es sich hierbei um Rasterelektronenmikroskopaufnahmen handelt, bei welchem Aluminium als strukturiertes Zielmaterial herangezogen wurde. Die erhaltene Linienbreite beträgt 400 nm. Aus den Photographien des Rasterelektronenmikroskops ist ersichtlich, dass mit dem erfindungsgemäßen Prägelack bzw. dem Verfahren zum Prägen scharfe Strukturen der Linienmuster erreicht werden können und dass keinerlei Reste der Resistschicht auf der Oberfläche der Strukturen verblieben sind.

### Beispiel 1:

### Herstellen eines Prägelacks gemäß der Erfindung

84 % Acryloylmorpholin (ACMO), 10 % 2-Ethylhexylthioglykolat, 5 % 2-Hydroxy-2-methyl-1-phenyl-propan-1-on als Photoinitiator sowie 1 % Polysiloxan-Tensid werden auf eine 50 µm starke PET-Folie mittels Tiefdruck aufgebracht, wobei das Schöpfvolumen der Tiefdruckwalze 1,6 ml/m² beträgt, was etwa einer 0,8 µm Nassschichtdicke entspricht und werden mit einem Nickelprägewerkzeug mit hervorstehenden Prägestrukturen mit 5 µm Strukturbreite und 1 µm Strukturhöhe mit einer Bahngeschwindigkeit von 10 m/min geprägt. Der pneumatische Druck an der Gegenwalze beträgt 4 Bar. Die UV-Polymerisation erfolgte durch Bestrahlung mit einer Hg-Mitteldruckdampflampe mit 100 W/cm.

### Beispiel 2

### Herstellen eines Prägelacks gemäß der Erfindung

84 % IOBA, 10 % 2-Glykoldi (3-mercaptopropional), 5 % 2-Hydroxy-2-methyl-1-phenyl-propan-1-on als Photoinitiator sowie 1 % 1H,1H,2H,2H-Perfluoroctylacrylat werden auf eine 50 µm starke PET-Folie mittels Tiefdruck aufgebracht, wobei das Näpfchenvolumen der Tiefdruckwalze 1,6 ml/m² beträgt, was etwa einer 0,8 µm Nassschichtdicke entspricht und werden mit einem Nickelprägewerkzeug mit hervorstehenden Prägestrukturen mit 5 µm Strukturbreite und 1 µm Strukturhöhe mit einer Bahngeschwindigkeit von 10 m/min geprägt. Der pneumatische Druck an der Gegenwalze beträgt 4 Bar. Die UV-Polymerisation erfolgte durch Bestrahlung mit einer Hg-Mitteldruckdampflampe mit 100 W/cm.

### Beispiel 3

### Herstellen eines Prägelacks gemäß der Erfindung

84 % Acryloylmorpholin (ACMO), 10 % Dodecanthiol, 5 % Ethyl(2,4,-trimethylbenzoyl)-phenylphospinat als Photoinitiator sowie 1 % 1H,1H,2H,2H-Perfluoroctylacetat werden auf eine 50 µm starke PET-Folie mittels Tiefdruck aufgebracht, wobei das Näpfchenvolumen der Tiefdruckwalze 1,6 ml/m² beträgt, was einer 0,8 µm Nassschichtdicke entspricht und werden mit einem Nickelprägewerkzeug mit hervorstehenden Prägestrukturen mit 5 µm Strukturbreite und 1 µm Strukturhöhe mit einer Bahngeschwindigkeit von 10 m/min geprägt. Der pneumatische Druck an der Gegenwalze beträgt 4,2 Bar. Die UV-Polymerisation erfolgte durch Bestrahlung mit einer Hg-Mitteldruckdampflampe mit 100 W/cm.

### Beispiel 4

### Herstellen eines Prägelacks gemäß der Erfindung

84 % IBOA, 10 % 2-Ethylhexylthioglykolat, 5 % Ethyl(2,4,-trimethylbenzoyl)phenylphospinate als Photoinitiator sowie 1 % Gemini-Siloxantensid werden auf eine 50 µm starke PET-Folie mittels Tiefdruck aufgebracht, wobei das Näpfchenvolumen der Tiefdruckwalze 1,6 ml/m² beträgt, was einer 0,8 µm Nassschichtdicke entspricht und werden mit einem Nickelprägewerkzeug mit hervorstehenden Prägestrukturen mit 5 µm Strukturbreite und 1 µm Strukturhöhe mit einer Bahngeschwindigkeit von 10 m/min geprägt. Der pneumatische Druck an der Gegenwalze beträgt 3,8 Bar. Die UV-Vernetzung erfolgte durch Bestrahlung mit einer Hg-Mitteldruckdampflampe mit 100 W/cm.

### Beispiel 5

Die gemäß Beispiel 1 hergestellten Strukturen werden durch Aufdampfen von 30 nm Nickel metallisiert und nach dem Metallisieren werden die Prägelackstrukturen durch Einbringen der metallisierten Folie in ein Wasserbad und Erwärmen auf Temperaturen von 40 °C und unter Anwenden von zusätzlichen Maßnahmen, wie Ultraschall, Sprühen, Bürsten, usw. abgelöst. Bei einer derartigen Behandlung wird der Prägelack, welcher wasserlöslich ist, gelöst und gleichzeitig mit dem Prägelack wird die über dem Prägelack befindliche Metallschicht abgelöst, während die sich direkt auf den im vorherigen Prägeschritt freigelegten Folienbereichen befindlichen Metallschichtbereiche auf der Folie verbleiben. So verbleibt nach dem Lift-Off-Prozess nur mehr eine negative Metallstruktur der geprägten Lackstruktur übrig.

### Beispiel 6

Die gemäß Beispiel 3 hergestellten Strukturen werden durch Aufdampfen von 30 nm Aluminium metallisiert und nach dem Metallisieren werden die überschüssigen Strukturen des Prägelacks durch Anwenden von Ultraschall in einem Wasserbad abgelöst. Bei einer derartigen Behandlung wird der wasserlösliche Prägelack gelöst und gleichzeitig mit dem Prägelack wird die über dem Prägelack befindliche Metallschicht abgelöst, so dass nach dem Lift-Off-Verfahren nur mehr ein negatives Profil des geprägten Profils übrig bleibt, welches ausschließlich aus einer Metallstruktur besteht.

### Beispiel 7

Die so hergestellten Strukturen werden durch Aufdampfen von 30 nm Chrom metallisiert und nach dem Metallisieren werden die überschüssigen Strukturen des Prägelacks durch Einbringen der metallisierten Struktur in ein Wasserbad und Erwärmen auf Temperaturen von 60 °C durch Sprühen und Druck durch Anwenden von Ultraschall und unter Anwenden von zusätzlichen Maßnahmen, wie Vibrieren, Bürsten, usw. abgelöst. Bei einer derartigen Behandlung wird der Prägelack, welcher wasserlöslich ist, gelöst und gleichzeitig mit dem Prägelack wird die über dem Prägelack befindliche Metallschicht abgelöst, so dass nach dem Lift-Off-Verfahren nur mehr ein negatives Profil des geprägten Profils übrig bleibt, welches ausschließlich aus einer Metallstruktur besteht.

### Beispiel 8

Die gemäß Beispiel 2 hergestellten Strukturen werden durch Aufdampfen von 30 nm Aluminium metallisiert und nach dem Metallisieren werden die überschüssigen Strukturen des Prägelacks durch Einbringen der metallisierten Struktur in Propylenglycolmonomethyletheracetat (PGMEA) und Erwärmen auf Temperaturen von 50 °C unter Anwenden von zusätzlichen Maßnahmen, wie Vibrieren, Bürsten, usw. abgelöst. Bei einer derartigen Behandlung wird der in Lösungsmittel lösliche Prägelack gelöst und gleichzeitig mit dem Prägelack wird die über dem Prägelack befindliche Metallschicht abgelöst, so dass nach dem Lift-Off-Verfahren nur mehr ein negatives Profil des geprägten Profils übrig bleibt, welches ausschließlich aus einer Metallstruktur besteht.

### Beispiel 9

Die gemäß Beispiel 4 hergestellten Strukturen werden durch Aufdampfen von 30 nm P3HT beschichtet und nach dem Beschichten werden die überschüssigen Strukturen des Prägelacks durch Einbringen der beschichteten Struktur in ein Wasserbad und Erwärmen auf Temperaturen von 50 °C oder durch Sprühen des Wassers und Druck abgelöst. Bei einer derartigen Behandlung wird der Prägelack gelöst und gleichzeitig mit dem Prägelack wird die über dem Prägelack befindliche Halbleiterschicht abgelöst, so dass nach dem Lift-Off-Verfahren nur mehr ein negatives Profil des geprägten Profils übrig bleibt, welches ausschließlich aus einer organischen Halbleiterstruktur besteht.

### Beispiel 10

Die gemäß Beispiel 4 hergestellten Strukturen werden durch Aufdampfen mit 30 nm ZnO beschichtet und nach dem Beschichten werden die überschüssigen Strukturen des Prägelacks durch Einbringen der beschichteten Struktur in Propylenglycolmonomethyletheracetat (PGMEA) und Erwärmen auf Temperaturen von 50 °C oder durch Sprühen des Lösungsmittels und Druck abgelöst. Bei einer derartigen Behandlung wird der Prägelack gelöst und gleichzeitig mit dem Prägelack wird die über dem Prägelack befindliche Halbleiterschicht abgelöst, so dass nach dem Lift-Off-Verfahren nur mehr ein negatives Profil des geprägten Profils übrig bleibt, welches ausschließlich aus einer anorganischen Halbleiterstruktur besteht.

## Patentansprüche

1. Prägelack basierend auf einer UV-polymerisierbaren Präpolymerzusammensetzung enthaltend wenigstens ein Acrylatmonomer, **dadurch gekennzeichnet, dass** die Präpolymerzusammensetzung neben dem Acrylatmonomeren wenigstens ein Thiol, gewählt aus der Gruppe: 3-Mercaptopropionate, Mercaptoacetate, Thioglycolate und Alkylthiole sowie ein oberflächenaktives Antihaftadditiv gewählt aus der Gruppe nicht-ionischen Tenside, wie Polyether-Siloxane, Fettalkoholethoxylate, wie Polyoxyethylen-(9)-laurylether, monofunktionellen Alkyl-(Meth-)Acrylate, Poly-Siloxan-(Meth-)Acrylate, Perfluoralkyl-(Meth-)Acrylate und Perfluorpolyether-(Meth-)Acrylate, sowie einen Photoinitiator enthält.

2. Prägelack nach Anspruch 1, **dadurch gekennzeichnet, dass** Acrylatmonomer aus Acryloylmorpholin (ACMO) oder Isobornylacrylat (IBOA) gewählt ist.

3. Prägelack nach Anspruch 1 oder 2, **dadurch gekennzeichnet, dass** das Thiol in einer Menge zwischen 0,5 und 20 Gew.-% der Präpolymerzusammensetzung enthalten ist.

4. Prägelack nach Anspruch 1, 2 oder 3, **dadurch gekennzeichnet, dass** das oberflächenaktive Antihaftadditiv ein silikonhaltiges oder fluorhaltiges Additiv, gewählt aus der Gruppe der nicht-ionischen Tenside wie Polyether-Siloxane, Fettalkoholethoxylate wie Polyoxyethylen-(9)-laurylether, monofunktionellen Polydimethylsiloxian-(meth-)acrylate, Perfluor-n-alkyl-(meth-)-acrylate oder Perfluorpolyether(meth-)-acrylate ist.

5. Prägelack nach Anspruch 4, **dadurch gekennzeichnet, dass** das oberflächenaktive Antihaftadditiv in einer Menge von 0,1 Gew.-% bis 3 Gew.-% enthalten ist.

6. Prägelack nach einem der Ansprüche 1 bis 5, **dadurch gekennzeichnet, dass** der Photoinitiator aus der Gruppe der Thioxanthone, Ketosulphone, (Alkyl-)Benzoyl-Phenyl-Phos-phinoxide, 1-Hydroxyalkylphenylketone oder 2,2-Dimethoxy-1,2-diphenylethan-1-on gewählt ist.

7. Prägelack nach Anspruch 6, **dadurch gekennzeichnet, dass** der Photoinitiator in einer Menge von 0,1 bis 10 Gew.-%, insbesondere 0,5 bis 5 Gew.-% enthalten ist.

8. Prägelack nach einem der Ansprüche 1 bis 7, **dadurch gekennzeichnet, dass** das Thiol aus einem Mono- oder Dithiol der Gruppe: Octanthiol, 1,8-Octandithiol, Decanthiol, 1,10-Decandithiol, Dodecanthiol, 1,12-Dodecandithiol, 2-Ethylhexylmercaptoacetat, 2-Ethylhexyl-3-mercaptopropionat, 2-Ethylhexylthioglycolat, Glycoldi-(3-mercaptoproprionat), Gykoldi(mercaptoacetat), Glyceryldimercaptoacetat oder Glyceryldi-(3-mercaptopropionat) gewählt ist.

9. Prägelack nach einem der Ansprüche 1 bis 8, **dadurch gekennzeichnet, dass** die Präpolymerzusammensetzung eine Viskosität zwischen 10 und 100mPas aufweist.

10. Verfahren zum Prägen von mit einem Prägelack gemäß einem der Ansprüche 1 bis 9 beschichteten Substratoberflächen, **gekennzeichnet, durch** die folgenden Schritte:
a) Aufbringen einer Schicht des Prägelacks auf einen Träger,
b) UV-Strukturieren des Prägelacks,
c) gegebenenfalls Aufbringen wenigstens einer weiteren zu strukturierenden Schicht gewählt aus einer Metall-, Halbleiter- und/oder Dielektrikumsschicht,
d) Ablösen des nach dem Strukturieren verbleibenden Prägelacks mit gegebenenfalls Zusätzen gewählt aus verdünnten Säuren mit pH-Werten im Bereich von 1 bis 6, verdünnten Laugen mit pH-Werten im Bereich von 8 bis 13 oder Tenside enthaltendem Wasser oder Propylenglycolmonomethyletheracetat (PGMEA), N-Methyl-2-pyrrolidon (NMP), Methylethylketon (MEK) oder Aceton.

11. Verfahren nach Anspruch 10, **dadurch gekennzeichnet, dass** die UV-Strukturierung des Prägelacks mit einem UV-Nanoimprintlithographieverfahren durchgeführt wird.

12. Verfahren nach Anspruch 10 oder 11, **dadurch gekennzeichnet, dass** die weitere zu strukturierende Metall-, Halbleiter- und/oder Dielektrikumsschicht mit einer Schichtdicke zwischen 5 nm und 500 nm aufgebracht wird.

13. Verfahren nach Anspruch 10, 11 oder 12, **dadurch gekennzeichnet, dass** die weitere zu strukturierende Schicht aus Metallen wie Nickel, Aluminium, Chrom oder Titan, konjugierten organischen Halbleitern wie Pentazen, C60, Thiophenen, DNTT; P3HT, Phthalocyaninen, H-brückengebundenen organischen Halbleitern, wie Indigo und Indigo-Derivaten sowie Quinacridon und Anthraquinon, anorganischen Halbleitern wie ZnO, SnO, InGaZnO oder Dielektrika, gewählt aus Polynorbornen, Ormocere, Cellulose, PVCi, BCB, PMMA, Schellack, Polyimid, Cytop, PVDF, PVDF-TrFE, Polystyrole, Al₂O₃, ZrO₂, SiO₂, SiON. Si₃N₄ sowie Kombinationen daraus, gewählt wird.

14. Verfahren nach einem der Ansprüche 10 bis 13, **dadurch gekennzeichnet, dass** das Ablösen des nach dem Strukturieren verbliebenen Prägelacks, durch Tauchen in ein Lösungsmittelbad oder durch Sprühen, gegebenenfalls mit zusätzlichen mechanischen Hilfsmitteln, wie Bürsten oder Ultraschall, durchgeführt wird.

## Claims

1. A resist based on a UV-polymerizable prepolymer composition containing at least one acrylate monomer, **characterized in that** the prepolymer compound contains, in addition to the acrylate monomer, a thiol selected from the group: 3-mercaptopropionates, mercaptoacetates, thioglycolates, and alkyl thiols, as well as a surface-active anti-adhesive additive selected from the group of anionic surfactants, such as polyether siloxanes, fatty alcohol ethoxylates, such as polyoxyethylene (9)-lauryl ethers, mono-functional alkyl (meth) acrylates, polysiloxane (meth) acrylate, perfluoroalkyl (meth) acrylates, and perfluoropolyether (meth) acrylate, as well as a photoinitiator.

2. The resist according to claim 1, wherein the acrylate monomer is selected from acryloylmorpholine (ACMO) or isobornyl acrylate (IBOA).

3. The resist according to claim 1 or 2, wherein the thiol is contained in the prepolymer composition in a quantity between 0.5 and 20 wt%.

4. The resist according to claim 1, 2 or 3, wherein the surface-active anti-adhesive additive is an additive containing silicone or fluoride selected from the group of anionic surfactants, such as polyether siloxanes, fatty alcohol ethoxylates, such as polyoxyethylene (9) lauryl ethers, mono-functional polydimethylsiloxane (meth) acrylates, perfluoro-n-alkyl (meth) acrylates or perfluoropolyether (meth) acrylates.

5. The resist according to claim 4, wherein the surface-active anti-adhesive additive is contained in a quantity of 0.1 wt% to 3 wt%.

6. The resist according to one of the claims 1 to 5, wherein the photoinitiator is selected from the group of thioxanthones, ketosulfones, (alkyl) benzoyl phenyl phosphine oxides, 1-hydroxy alkyl phenyl ketones or 2,2-dimethoxy-1,2-diphenylethane-1-one.

7. The resist according to claim 6, wherein the photoinitiator is contained in a quantity of 0.1 to 10 wt%, particularly 0.5 to 5 wt%.

8. The resist according to one of the claims 1 to 7, wherein the thiol is selected from a mono or dithiol of the group:
octanethiol, 1,8-octanedithiol, decanethiol, 1,10-decanedithiol, dodecanethiol, 1,12-dodecanedithiol, 2-ethylhexyl mercaptoacetate, 2-ethyl-hexyl-3-mercaptopropionate, 2-ethylhexyl thioglycolate, glycol di-(3-mercaptoproprionate), glycol di(mercaptoacetates), glyceryl dimercaptoacetate or glyceryl di-(3-mercaptopropionate).

9. The resist according to one of the claims 1 to 8, wherein the prepolymer composition has a viscosity between 10 and 100mPas.

10. A method for imprinting substrate surfaces coated with a resist according to one of the claims 1 to 9, **characterized by** the following steps:
a) application of a layer of resist on a carrier,
b) UV structuring of the resist,
c) potential application of at least one additional layer to be structured selected from a metal, semiconductor, and/or dielectric layer,
d) removal of the resist remaining after structuring with potential additives selected from diluted acids with pH values in the range of 1 to 6, diluted alkalis with pH values in the range of 8 to 13 or water containing surfactants or propylene glycol monomethyl ether acetate (PGMEA), N-methyl-2-pyrrolidone (NMP), methyl ethyl ketone (MEK) or acetone.

11. The method according to claim 10, **characterized in that** the UV structuring of the resist is conducted with a UV nanoimprint lithography method.

12. The method according to claim 10 or 11, **characterized in that** the additional metal, semiconductor, and/or dielectric layer to be structured is applied with a layer thickness between 5 nm and 500 nm.

13. The method according to claim 10, 11 or 12, **characterized in that** the additional layer to be structured is selected from metals, such as nickel, aluminum, chrome or titanium, conjugated organic semiconductors, such as pentazen, C60, thiophene, DNTT; P3HT, phthalocyanine, hydrogen bridge-bonded organic semiconductors, such as indigo and indigo derivatives as well as quinacridone and anthraquinone, inorganic semiconductors, such as ZnO, SnO, InGaZnO or dielectrics selected from polynorbornene, ormocer, cellulose, PVCi, BCB, PMMA, shellac, polyimide, Cytop, PVDF, PVDF-TrFE, polystyrenes, Al₂O₃, ZrO₂, SiO₂, SiON, Si₃N₄, as well as combinations thereof.

14. The method according to one of the claims 10 to 13, **characterized in that** the removal of the resist remaining after structuring is conducted through immersion in a solvent bath or by spraying potentially with additional mechanical means, such as brushes or ultrasound.

## Revendications

1. Peinture d'impression en relief à base d'une composition prépolymère polymérisable par UV contenant au moins un monomère d'acrylate, **caractérisée en ce que** la composition prépolymère contient, en plus du monomère d'acrylate, au moins un thiol choisi dans le groupe comprenant des 3-mercaptopropionates, des mercapto-acétates, des thioglycolates et des alkylthiols ainsi qu'un additif anti-adhérence tensioactif choisi dans le groupe des tensioactifs non-ioniques, tels que des polyéther-siloxanes, des éthoxylates d'alcool gras tels que le polyoxyéthylène-(9)-lauryléther, des alkyl-(méth-)-acrylates monofonctionnels, des polysiloxane-(méth-)-acrylates, des perfluoroalkyl-(méth-)-acrylates et des perfluoropolyéther-(méth-)-acrylates, ainsi qu'un photoinitiateur.

2. Peinture d'impression en relief selon la revendication 1, **caractérisée en ce que** le monomère d'acrylate est choisi parmi l'acryloylmorpholine (ACMO) ou l'acrylate d'isobornyle (IBOA).

3. Peinture d'impression en relief selon une revendication 1 ou 2, **caractérisée en ce que** le thiol est contenu en une quantité comprise entre 0,5 et 20 % en poids de la composition prépolymère.

4. Peinture d'impression en relief selon une revendication 1, 2 ou 3, **caractérisée en ce que** l'additif anti-adhérence tensioactif est un additif contenant du silicone ou contenant du fluor, choisi dans le groupe des tensioactifs non-ioniques tels que les polyéther-siloxanes, des éthoxylates d'alcool gras tels que le polyoxyéthylène-(9)-lauryléther, des polydiméthyl-siloxane-(méth-)-acrylates monofonctionnels, des perfluoro-n-alkyl-(méth-)-acrylates ou des perfluoro-polyéther-(méth-)-acrylates.

5. Peinture d'impression en relief selon la revendication 4, **caractérisée en ce que** l'additif anti-adhérence tensioactif est contenu en une quantité comprise entre 0,1 % en poids et 3 % en poids.

6. Peinture d'impression en relief selon l'une quelconque des revendications 1 à 5, **caractérisée en ce que** le photoinitiateur est choisi dans le groupe des thioxanthones, des cétosulfones, des (alkyl-)benzoyl-phényl-phosphinoxydes, des 1-hydroxyalkylphénylcétones ou le 2,2-diméthoxy-1,2-diphényléthane-1-one.

7. Peinture d'impression en relief selon la revendication 6, **caractérisée en ce que** le photoinitiateur est contenu en une quantité de 0,1 à 10 % en poids, en particulier de 0,5 à 5 % en poids.

8. Peinture d'impression en relief selon l'une quelconque des revendications 1 à 7, **caractérisé en ce que** le thiol est choisi parmi un mono- ou dithiol du groupe: octanethiol, 1,8-octanedithiol, décanethiol, 1,10-décanedithiol, dodécanethiol, 1,12-dodécanedithiol, 2-éthylhexylmercaptoacétate, 2-éthylhexyl-3-mercaptopropionate, 2-éthylhexylthioglycolate, glycoldi-(3-mercaptopropionate), glycoldi(mercaptoacétate), glycéryldimercaptoacétate ou glycéryldi-(3-mercapto-propionate).

9. Peinture d'impression en relief selon l'une quelconque des revendications 1 à 8, **caractérisée en ce que** la composition prépolymère présente une viscosité comprise entre 10 et 100 mPas.

10. Procédé d'impression en relief de surfaces de substrat recouvertes d'une peinture d'impression en relief selon l'une quelconque des revendications 1 à 9, **caractérisé par** les étapes suivantes:
a) appliquer une couche de la peinture d'impression en relief sur un support,
b) structurer la peinture d'impression en relief par UV,
c) éventuellement appliquer au moins une autre couche à structurer choisie parmi une couche de métal, de semi-conducteur et/ou de diélectrique,
d) dissoudre la peinture d'impression en relief restant après la structuration éventuellement avec des ajouts choisis parmi des acides dilués présentant des pH compris dans la plage de 1 à 6, des lessives diluées présentant des pH compris dans la plage de 8 à 13 ou de l'eau contenant des tensioactifs ou l'acétate de propylèneglycolmonométhyléther (PGMEA), la N-méthyl-2-pyrrolidone (NMP), la méthyléthylcétone (MEK) ou l'acétone.

11. Procédé selon la revendication 10, **caractérisé en ce que** l'on effectue la structuration par UV de la peinture d'impression en relief avec un procédé de lithographie par nano-impression sous UV.

12. Procédé selon une revendication 10 ou 11, **caractérisé en ce que** l'on dépose l'autre couche à structurer en métal, en semi-conducteur et/ou en diélectrique avec une épaisseur de couche comprise entre 5 nm et 500 nm.

13. Procédé selon une revendication 10, 11 ou 12, **caractérisé en ce que** l'on choisit l'autre couche à structurer parmi des métaux tels que le nickel, l'aluminium, le chrome ou le titane, des semi-conducteurs organiques conjugués tels que le pentazène, le C60, les thiophènes, le DNTT;P3HT, les phtalocyanines, des semi-conducteurs organiques à pontage H, tels que l'indigo et les dérivés de l'indigo ainsi que la quinacridone et l'anthraquinone, des semi-conducteurs inorganiques tels que ZnO, SnO, InGaZnO ou des diélectriques, choisis parmi le polynorbornène, l'ormocère, la cellulose, le PVCi, le BCB, le PMMA, la gomme-laque, le polyimide, le Cytop, le PVDF, le PVDF-TrFE, les polystyrènes, Al₂O₃, ZrO₂, SiO₂, SiON. Si₃N₄, ainsi que des combinaisons de ceux-ci.

14. Procédé selon l'une quelconque des revendications 10 à 13, **caractérisé en ce que** l'on effectue la dissolution de la peinture d'impression en relief restant après la structuration par immersion dans un bain de solvant ou par pulvérisation, éventuellement avec des moyens mécaniques accessoires supplémentaires comme le brossage ou les ultrasons.
